(19) Europäisches Patentamt
European Patent Office
Office européen des brevets

(11) **EP 2 991 087 B1**

(12) **EUROPÄISCHE PATENTSCHRIFT**

(45) Veröffentlichungstag und Bekanntmachung des Hinweises auf die Patenterteilung:
**04.10.2017 Patentblatt 2017/40**

(51) Int Cl.:
*H01H 3/28* (2006.01)    *G01R 31/327* (2006.01)
*G01R 19/165* (2006.01)    *G01R 31/02* (2006.01)
*H01H 23/22* (2006.01)    *H01H 47/00* (2006.01)
*H01H 51/00* (2006.01)    *H01H 73/36* (2006.01)

(21) Anmeldenummer: **15182623.7**

(22) Anmeldetag: **27.08.2015**

(54) **ELEKTRISCHER SCHALTER**

ELECTRIC SWITCH

COMMUTATEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.08.2014 DE 102014012589**
**29.08.2014 DE 102014012555**

(43) Veröffentlichungstag der Anmeldung:
**02.03.2016 Patentblatt 2016/09**

(73) Patentinhaber: **Marquardt Mechatronik GmbH**
**78604 Rietheim-Weilheim (DE)**

(72) Erfinder:
• **Volk, Sebastian**
**78052 Villingen-Schwenningen (DE)**
• **Maier, Andreas**
**78737 Fluorn-Winzeln (DE)**
• **Geiger, August**
**78607 Talheim (DE)**

(74) Vertreter: **Otten, Roth, Dobler & Partner mbB**
**Patentanwälte**
**Großtobeler Straße 39**
**88276 Berg / Ravensburg (DE)**

(56) Entgegenhaltungen:
EP-A2- 1 096 262    EP-A2- 2 405 539
DE-A1-102013 008 128    DE-C1- 4 001 509

EP 2 991 087 B1

**Beschreibung**

Die Erfindung betrifft einen elektrischen Schalter nach dem Oberbegriff des Patentanspruchs 1.

Solche elektrischen Schalter dienen zum Ein- und/oder Ausschalten von elektrischen Geräten durch eine manuelle Betätigung eines Benutzers. Insbesondere werden diese Schalter beispielsweise in der Hausgeräteindustrie für Haushaltsgeräte, wie Kaffeemaschinen, Staubsauger o. dgl., für Geräte in der Unterhaltungsindustrie etc. eingesetzt. Solche Schalter können in der Art eines Wippschalters ausgestaltet sein.

Aus der DE 10 2013 008 128 A1 ist ein derartiger elektrischer Schalter, der ein Gehäuse besitzen kann, bekannt. Im Gehäuse befindet sich ein Kontaktsystem. Aus dem Gehäuse ragt ein bewegliches Betätigungsorgan zum manuellen Umschalten des Kontaktsystems zwischen zwei Schaltstellungen, nämlich einer Ausschalt-Stellung und einer Einschalt-Stellung, heraus. Im Gehäuse befindet sich weiter ein ansteuerbarer Aktor, bei dessen Ansteuerung das Kontaktsystem nichtmanuell in die andere Schaltstellung geschaltet wird. Und zwar kann das Kontaktsystem mittels des Aktors insbesondere von der Einschalt- in die Ausschalt-Stellung nichtmanuell geschaltet werden.

Desweiteren weist der Schalter ein Mittel zur Messung des durch den Schalter fließenden elektrischen Stroms auf. Und zwar umfasst das Mittel zur Strommessung einen Widerstand sowie einen Verstärker. Der Widerstand befindet sich im Gehäuse, so dass der Widerstandswert aufgrund der am Widerstand entstehenden Wänne, die aus dem Gehäuse abgeführt werden muss, begrenzt ist. Dies bedingt wiederum, dass ein hoch verstärkender und damit teurer Verstärker benötigt wird.

Ein weiterer elektrischer Schalter, bei dem das Kontaktsystem ebenfalls mittels eines Aktors von der Einschalt- in die Ausschalt-Stellung nichtmanuell geschaltet werden kann, ist aus der EP 2 405 539 A2 bekannt. In Zusammenwirkung mit diesem Schalter steht ein Mittel zur Messung des in einer Versorgungsleitung fließenden elektrischen Stroms. Hier umfasst das Mittel zur Strommessung einen Widerstand sowie einen Komparator.

Der Erfindung liegt die Aufgabe zugrunde, den Schalter derart weiterzuentwickeln, dass das Mittel zur Strommessung, insbesondere bei erhöhter Leistungsfähigkeit, kostengünstiger ist.

Diese Aufgabe wird bei einem gattungsgemäßen elektrischen Schalter durch die kennzeichnenden Merkmale des Anspruchs 1 gelöst.

Beim erfindungsgemäßen elektrischen Schalter umfasst das Mittel zur Strommessung einen Verstärker, wobei der Verstärker aus zwei Stromspiegeln besteht. Bevorzugterweise handelt es sich dabei um zwei komplementär aufgebaute Stromspiegel. Vorteilhafterweise ist bei einem solchen Schalter die Genauigkeit der Strommessung gesteigert, wobei dieser Schalter dennoch kostengünstiger als bisher ist. Weitere Ausgestaltungen der Erfindung sind Gegenstand der Unteransprüche.

In einer einfachen und kostengünstigen Ausgestaltung kann der Stromspiegel jeweils zwei Transistoren umfassen. Desweiteren kann eine Reihenschaltung aus zwei Widerständen zum Einprägen des Stroms in die Basen der Transistoren der beiden Stromspiegel vorgesehen sein. Die Spannung kann am mittleren Abgriff der Reihenschaltung der beiden Widerstände dem gemeinsamen Kollektor der Transistoren des ersten Stromspiegels zugeführt werden. Bevorzugterweise kann der vom gemeinsamen Kollektor der Transistoren des ersten Stromspiegels gebildete Knotenpunkt als Referenz verwendet werden. Die Spannung kann desweiteren am mittleren Abgriff der Reihenschaltung der beiden Widerstände dem gemeinsamen Kollektor der Transistoren des zweiten Stromspiegels zugeführt werden. Bevorzugterweise kann an dem vom gemeinsamen Kollektor der Transistoren des zweiten Stromspiegels gebildeten Knotenpunkt über einen Kondensator sowie gegebenenfalls einen weiteren Spannungsteiler das Nutzsignal abgegriffen werden.

In einfacher Art und Weise kann der Widerstand in der Art eines Stromshunts zwischen dem Emitter des einen Transistors des zweiten Stromspiegels und der Masse angeordnet sein. Der Widerstand kann als eine mäanderförmige Bahn an einem elektrischen Anschluss des Schalters ausgestaltet sein, was besonders kostengünstig ist und/oder fertigungstechnisch einfach herstellbar ist.

Zwecks Weiterverarbeitung des Signals kann ein AD(Analog/Digital)-Wandler mit dem Ausgang für das Nutzsignal zur Auswertung des Nutzsignals in Verbindung stehen. Insbesondere kann diese Auswertung im Hinblick auf die Bestimmung der Größe des elektrischen Stroms erfolgen. Ebenso kann ein Komparator mit dem Ausgang für das Referenzsignal sowie mit dem Ausgang für das Nutzsignal zur Auswertung des Differenzsignals zwischen dem Referenzsignal und dem Nutzsignal in Verbindung stehen. Insbesondere kann diese Auswertung wiederum im Hinblick auf die Bestimmung der Größe des elektrischen Stroms erfolgen. In einfacher Art und Weise kann die Auswertung des Nutzsignals und/oder des Referenzsignals ein PWM(Puls-Weiten-Moduliertes)-Signal erzeugen. Zweckmäßigerweise kann dabei das Tastverhältnis des PWM-Signals zur Größe des elektrischen Stroms korrespondierend sein.

In kompakter sowie auch funktionssicherer Ausgestaltung kann der ansteuerbare Aktor mit dem Betätigungsorgan in Wirkverbindung stehen. Dadurch kann das Betätigungsorgan in wenigstens einer der beiden Schaltstellungen bei Ansteuerung des Aktors vom Aktor zum Schalten des Kontaktsystems in die andere Schaltstellung bewegt werden.

In bevorzugter Weise handelt es sich bei dem Aktor um einen eine Spule sowie einen Anker aufweisenden Elektromagneten. Die Wirkverbindung zwischen dem Aktor und dem Betätigungsorgan kann mittels des Ankers bewirkt werden, womit eine besonders kompakte Ausgestaltung resultiert. In einfacher Art und Weise kann hierzu der Anker mittels eines Stößels auf das Betätigungsorgan, und zwar bevorzuterweise auf einen Ansatz am Betätigungsorgan, einwirken.

Für eine besonders bevorzugte Ausgestaltung des erfindungsgemäßen elektrischen Schalters ist nachfolgendes festzustellen.

Geschaffen ist ein die Messung eines elektrischen Stroms, insbesondere eines Wechselstroms, unter Zuhilfenahme eines Komparators gestattendes Schaltelement, das nichtmanuell und/oder manuell schaltbar ist, ein sogenannter ECO-Schalter.

Ein Merkmal des ECO-Schalters in der Art eines Auto-off-Schalters mit Stromerkennung ist die eigenständige Erkennung der Arbeitsmodi und dem Kundenwunsch entsprechender Reaktion darauf. Die Erkennung der Arbeitsmodi erfolgt durch das Einlesen bzw. das Messen und der Interpretation des Arbeitsstroms. Der Stromfluss hat einen kleinen Spannungsabfall am Mäanderwiderstand, das aus einem Stanzteil bestehen kann, zur Folge. Den Widerstandswert des Mäanders kann man aufgrund einer gleichzeitigen Erhöhung der Erwärmung nicht vergrößern.

Es wird daher ein hoch verstärkender Verstärker benötigt, der auch bei stark schwankenden Umwelteinflüssen ein stabiles Ausgangssignal liefert. Es wird ein kostengünstiger und Strom sparender AD(Anlog/Digital)-Wandler benötigt, der auch bei kleinen Amplituden eine hohe Auflösung hat.

Für die Hardware ist nachfolgendes festzustellen.

Zum Aufbau:

Der Verstärker besteht aus zwei komplementär aufgebauten doppelten Stromspiegeln. Der Strom in die Basen der beiden Stromspiegel wird durch eine Reihenschaltung aus zwei Widerständen eingeprägt. Die Spannung am mittleren Abgriff der Reihenschaltung wird dem gemeinsamen Kollektor des ersten Stromspiegelzweigs zugeführt und stabilisiert so durch Spannungsgegenkopplung den Strom in diesem. Dieser Knotenpunkt (Kollektor des ersten Stromspiegelzweigs) wird als Referenz (K1) verwendet. Durch Stromspiegelung wird in den zweiten Stromzweig derselbe Stromwert eingeprägt. Der gemeinsame Kollektor im zweiten Stromzweig, geht über einen Kondensator auf einen weiteren Spannungsteiler und bildet das Nutzsignal (K2). Zwischen den Emitter und der Masse des zweiten Stromzweigs ist ein Stromshunt integriert, in welchen das Rohsignal eingespeist wird.

Zur Funktion:

Der zweite Stromkreis arbeitet als Transimpedanzverstärker mit einer Stromquelle als Kollektorwiderstand. Beim Bestromen des Stromshunts wird das Potenzial des besagten Emitters angehoben und ändert somit die Stromverhältnisse im zweiten Stromspiegelzweig. Die beschriebene Änderung der Stromverhältnisse wirkt sich gleichzeitig aber in umgekehrter Weise im ersten Stromzweig auch aus. Die Spannungsgegenkopplung des ersten Stromzweigs verhindert allerdings eine Änderung der Stromverhältnisse in diesem und spiegelt als Reaktion die Stromänderung in die als Kollektorwiderstand dienende Stromquelle des zweiten Stromzweigs.

Zur Auswertung:

Der Verstärkerausgang K2 kann direkt mit einem AD-Wandler oder als Differenzsignal von K1 und K2 durch einen Komparator ausgewertet werden. Dabei wird die Kreuzung der Signale K1 und K2, die sich ab einer gewissen Stromstärke einstellt, ausgewertet. Das Ergebnis ist ein von dem Strom im Stromshunt abhängiges PWM(Pulsweitenmodulations)-Signal. Ist die Kurvenform des Stroms bekannt, und zwar handelt es sich in der Regel um ein Sinussignal, so lässt sich die Stromamplitude aus dem Tastverhältnis des PWM-Signals eindeutig bestimmen. In der Software eines zur Auswertung verwendeten Mikroprozessors kann entweder direkt die mathematische Beziehung hinterlegt werden oder mittels einer Zuordnungstabelle auf die Stromamplitude zurückgeschlossen werden.

Die mit der Erfindung erzielten Vorteile bestehen insbesondere darin, dass durch die erfindungsgemäße Art der Beschaltung im Vergleich zu einem einfachen Transimpedanzverstärker eine doppelte Verstärkung erreicht wird. Die Auskopplung des Nutzsignals über einen Kondensator unterbindet langsam ablaufende Temperatureffekte. Es ist vorteilhafterweise eine echte und genaue Strommessung beim Kennen der Stromform ermöglicht. Der Schalter ist robust gegen Umweltstörgrößen. Durch Verzicht auf einen AD-Wandler wird eine Verkleinerung des Strombedarfs bewirkt, was insbesondere bei Einsatz von resistiven Netzteilen vorteilhaft ist, und eine Kosteneinsparung erzielt. Außerdem ergibt sich dadurch eine kostengünstige Realisierung einer genauen Strommessung.

Ausführungsbeispiele der Erfindung mit verschiedenen Weiterbildungen und Ausgestaltungen sind in den Zeichnungen dargestellt und werden im folgenden näher beschrieben. Es zeigen

Fig. 1a, b, c        einen elektrischen Schalter in Seiten-, Front- und Unteransicht,

Fig. 2a, b, c          diverse Schnitte durch den elektrischen Schalter aus Fig. 1a, b, c,

Fig. 3                 den Schalter aus Fig. 1a, b, c mit geöffnetem Gehäuse, wobei sich der Schalter in der Einschalt-Stellung befindet und der Anker in unterer Endposition ist,

Fig. 4                 den Schalter wie in Fig. 3, wobei sich der Schalter in einer Zwischenposition während des Ausschalt-Vorganges befindet und der Anker in Zwischen-position ist,

Fig. 5                 den Schalter wie in Fig. 3, wobei sich der Schalter in der Ausschalt-Stellung befindet und der Anker in oberer Endposition ist,

Fig. 6a, b             ein schematisches Schaltbild mit Anschlussbelegung für den Anschluss des elektrischen Schalters,

Fig. 7a, b, c, d, e    diverse Ansichten des Schalters mit Schaltbild gemäß einer abermals weiteren Ausführung, wobei in Fig. 7a die Anschlussbelegung, in Fig. 7b das schematische Schaltbild sowie in Fig. 7c die Baugruppe mit vollständigem Modul zu sehen ist,

Fig. 8a, b             das Schaltbild sowie den Funktionsablauf für den Schalter gemäß einer wiederum weiteren Ausführung, wobei in Fig. 8b die grafische Beschreibung der Strommessung zu sehen ist.

Fig. 9                 die Schaltungsanordnung für den Verstärker aus Fig. 8a,

Fig. 10                ein schematisches Blockschaltbild umfassend den Schalter sowie einen externen Sensor entsprechend einem ersten Ausführungsbeispiel,

Fig. 11                ein schematisches Blockschaltbild umfassend den Schalter sowie einen externen Sensor entsprechend einem zweiten Ausführungsbeispiel und

Fig. 12                ein schematisches Blockschaltbild umfassend den Schalter sowie einen externen Sensor entsprechend einem dritten Ausführungsbeispiel.

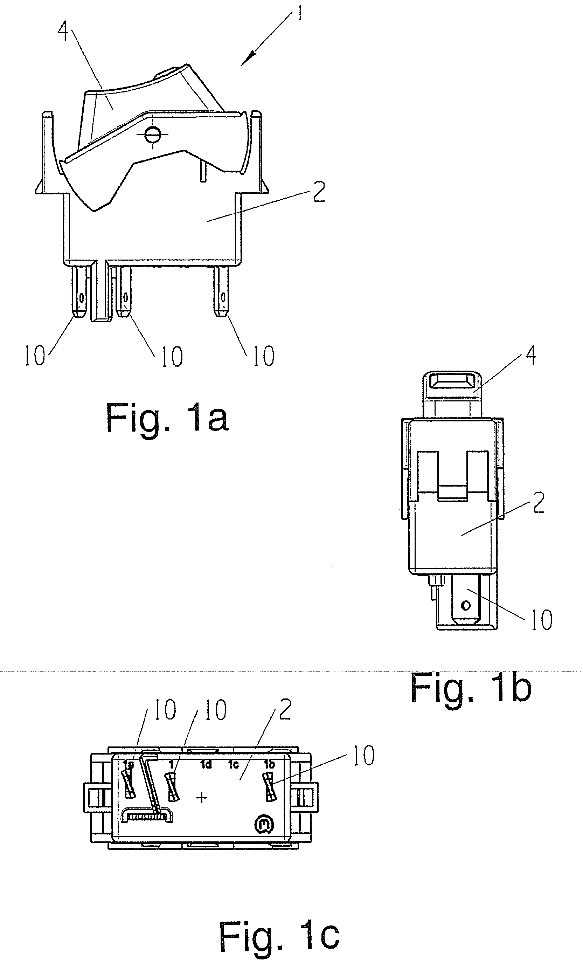

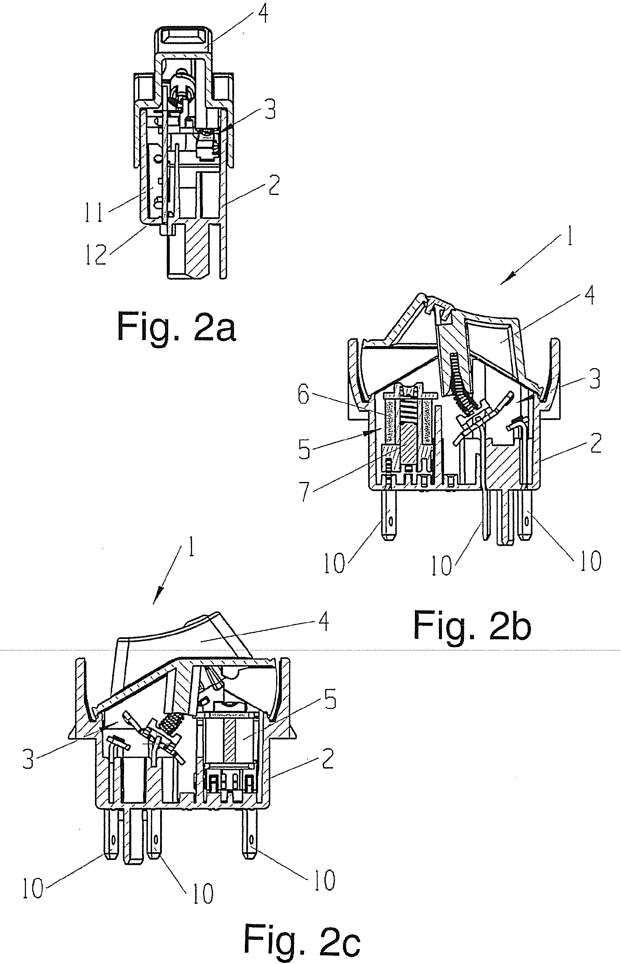

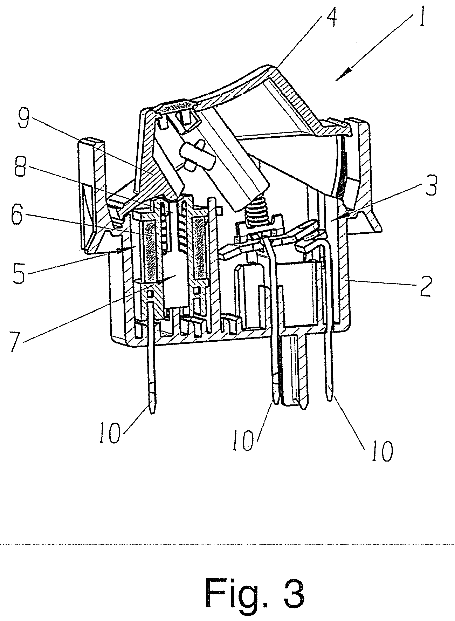

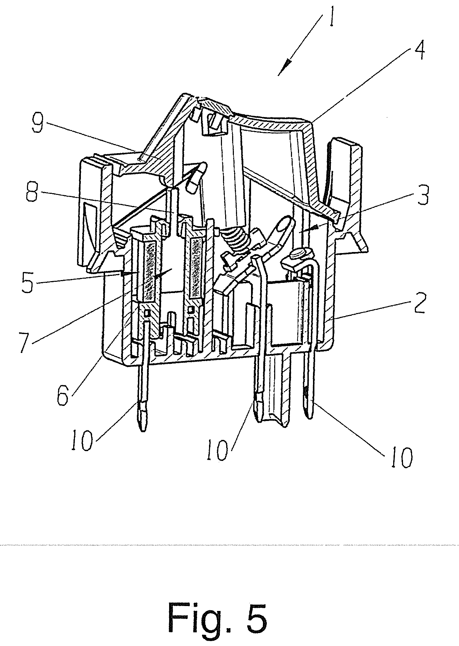

In Fig. 1a, Fig. 1b und Fig. 1c ist ein elektrischer Schalter 1 zu sehen, der als ein Wippschalter ausgebildet ist. Der Schalter 1 besitzt ein Gehäuse 2. Im Inneren des Gehäuses 2 befindet sich ein Kontaktsystem 3, wie in Fig. 2a, Fig. 2b und Fig. 2c zu erkennen ist. Zur Zuführung der elektrischen Spannung zum Kontaktsystem 3 ragen aus dem Gehäuse 2 elektrische Anschlüsse 10 heraus. Der Schalter 1 besitzt weiter ein aus dem Gehäuse 2 herausragendes, bewegliches Betätigungsorgan 4, das vorliegend als Wippe ausgestaltet ist, zum manuellen Umschalten des Kontaktsystems 3 durch den Benutzer zwischen zwei Schaltstellungen, nämlich einer in Fig. 3 gezeigten Einschalt-Stellung sowie einer in Fig. 5 gezeigten Ausschalt-Stellung. Schließlich befindet sich noch ein ansteuerbarer Aktor 5 im Gehäuse 2, der gemäß Fig. 3 mit dem Betätigungsorgan 4 in Wirkverbindung steht, derart dass das Betätigungsorgan 4 in wenigstens einer der beiden Schaltstellungen bei Ansteuerung des Aktors 5 vom Aktor 5 zum Schalten des Kontaktsystems 3 in die andere Schaltstellung bewegt wird. Insbesondere handelt es sich bei dem Schalter 1 um einen selbstabschaltbaren Schalter, so dass das Betätigungsorgan 4 vom Aktor 5 von der Einschalt- in die Ausschalt-Stellung des Kontaktsystems 3 bewegt wird. Selbstverständlich kann der Aktor 5 anstelle von dessen Einwirkung auf das Betätigungsorgan 4 auch in sonstiger Weise mit dem Kontaktsystem 3 zu dessen Umschaltung zusammenwirken, was jedoch nicht weiter gezeigt.

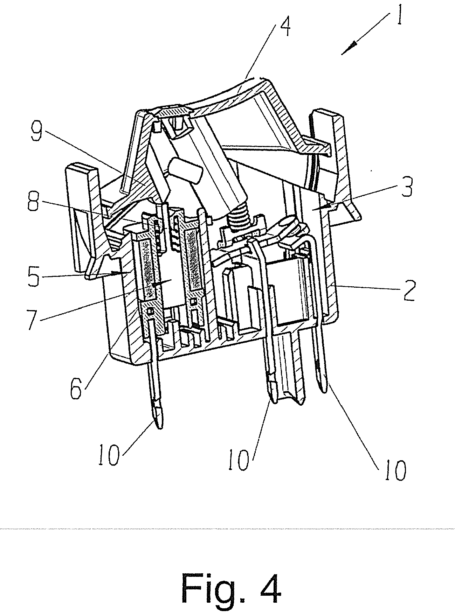

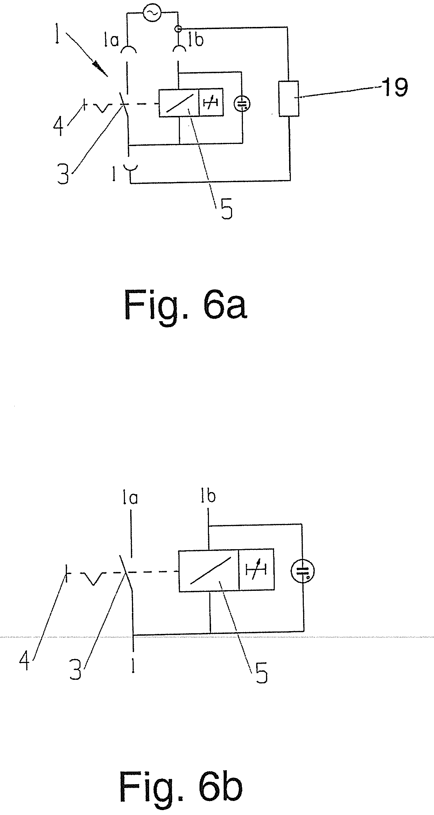

Wie anhand der Fig. 2b zu erkennen ist, handelt es sich bei dem Aktor 5 um einen eine Spule 6 sowie einen Anker 7 aufweisenden Elektromagneten. Die Wirkverbindung zwischen dem Aktor 5 und dem Betätigungsorgan 4 wird mittels des Ankers 7 bewirkt. Hierzu wirkt der Anker 7 mittels eines Stößels 8 auf einen Ansatz 9 am Betätigungsorgan 4 ein, wie dem Ausschaltvorgang beim Selbstabschalten gemäß der Fig. 3 bis Fig. 5 zu entnehmen ist. Das Schaltbild mitsamt Anschlussbelegung für den den Aktor 5 aufweisenden selbstabschaltenden Schalter 1 ist näher in Fig. 6a und Fig. 6b zu sehen. Wie aus der Fig. 6a weiter hervorgeht, wird der die Last 19 enthaltende Lastkreis für den Schalter 1 sowie der Ansteuerkreis für den Aktor 5 mit derselben Spannung betrieben. In einer weiteren Ausführung, die allerdings nicht näher dargestellt ist, wird der Lastkreis des Schalters 1 vom Ansteuerkreis des Aktors 5 getrennt. Dadurch kann dann der Ansteuerkreis mittels Niedervolt betrieben werden. Zur Trennung des Last- und Ansteuerkreises kann ein OptoKoppler verwendet werden.

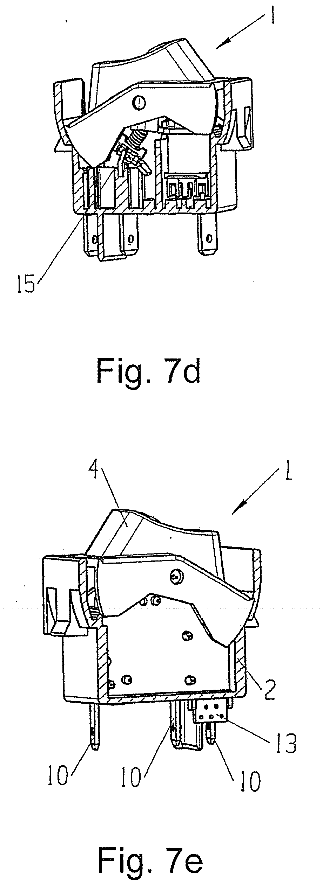

Der Schalter 1 weist eine programmierbare Elektronik 11 auf, wie in Fig. 2a zu sehen ist. Die Elektronik 11 ist auf einer im Gehäuse 2 befindlichen Leiterplatte 12 angeordnet. Die Elektronik 11 umfasst einen Timer zur gesteuerten Bewegung des Betätigungsorgans 4 in die andere Schaltstellung des Kontaktsystems 3. Hierzu weist die Elektronik 11 einen Mikrocontroller bzw. einen Mikroprozessor auf, wobei eine Zeitspanne in der Art einer Abschaltzeit in den Mikrocontroller bzw. den Mikroprozessor programmierbar ist, derart dass die Elektronik 11 bei Ablauf der Zeitspanne den Aktor 5 zum Schalten des Kontaktsystems 3 ansteuert. Zur Programmierung der gewünschten Zeitspanne befindet sich an der Leiterplatte 12 eine Programmierlasche 13, die gemäß Fig. 7e durch einen Schlitz im Gehäuse 2 nach außen geführt ist, derart dass mittels Kontaktierungspunkten an der Programmierlasche 13 das Programmieren des Schalters 1, beispielsweise bei dessen Herstellung, ermöglicht ist.

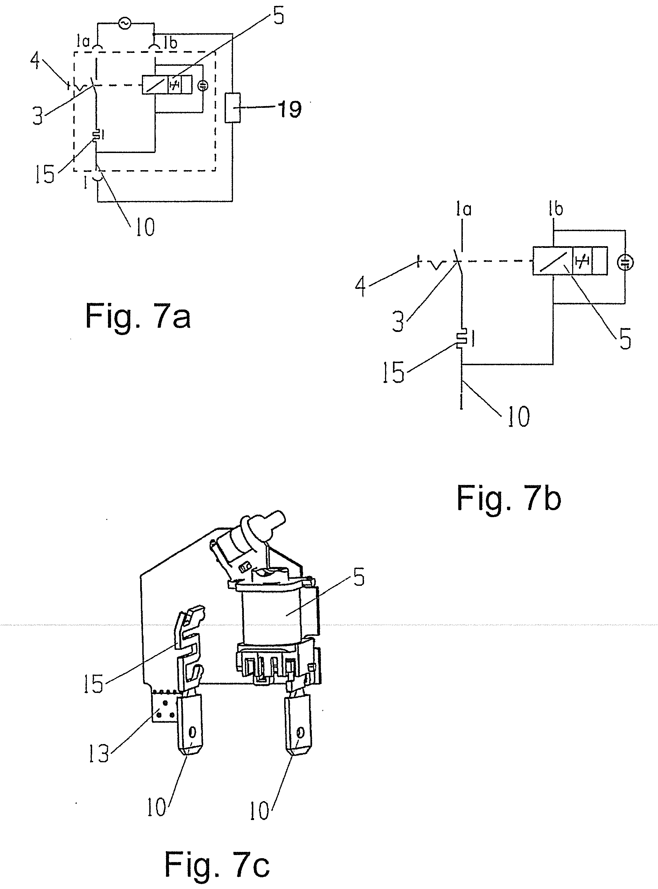

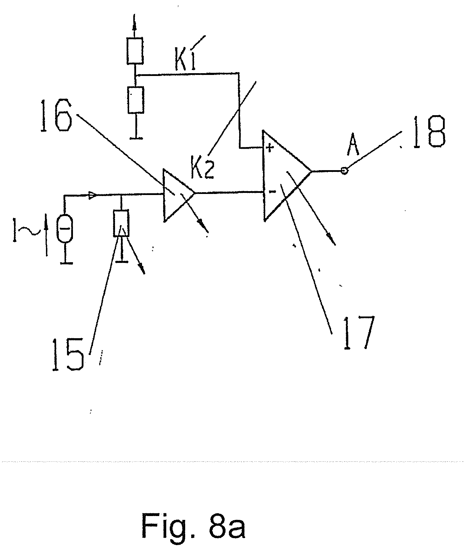

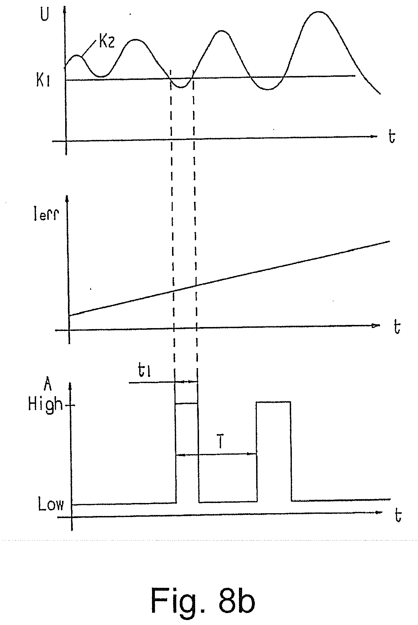

Bei einer weiteren Ausführung, die in Fig. 7a, Fig. 7b, Fig. 7c, Fig. 7d sowie Fig. 7e und Fig. 8a sowie Fig. 8b gezeigt ist, ist ein Mittel zur Messung des durch den Schalter 1 fließenden elektrischen Stroms vorgesehen. Dieses Mittel zur Strommessung umfasst einen Widerstand 15, einen Verstärker 16 sowie einen Komparator 17. Der Widerstand 15 ist gemäß Fig. 7c als eine mäanderförmige Bahn an dem einen elektrischen Anschluss 10 ausgebildet. Wie weiter aus Fig. 8b hervorgeht, wird die Größe des gemessenen Stroms als Tastverhältnis in der Art eines Puls-Weiten-Signals (PWM-Signals) am Ausgang 18 des Komparators 17 ausgegeben. Dabei ist

$$I_{eff} \sim \frac{t_l}{T} = \lambda$$

das Tastverhältnis $\lambda$ am Komparatorausgang A.

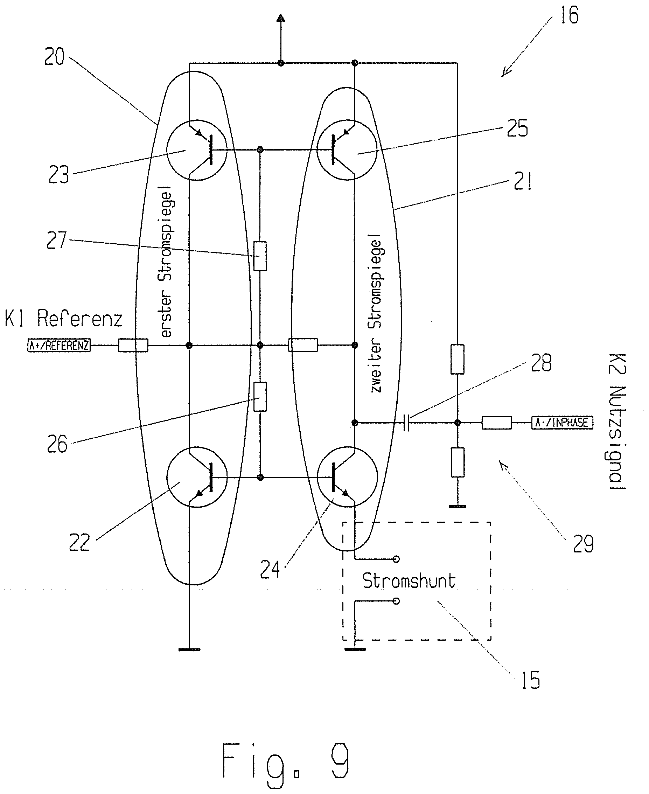

Wie man anhand von Fig. 9 erkennt, in der die nähere Ausgestaltung des Verstärkers 16 sowie dessen Schaltungsanordnung zu sehen ist, besteht der Verstärker 16 aus zwei komplementär aufgebauten Stromspiegeln 20, 21 in der Art eines doppelten Transimpedanzverstärkers. Der Stromspiegel 20, 21 umfasst jeweils zwei Transistoren 22, 23, 24, 25. Eine Reihenschaltung aus zwei Widerständen 26, 27 ist zum Einprägen des Stroms in die Basen der Transistoren 22, 23, 24, 25 der beiden Stromspiegel 20, 21 vorgesehen.

Die Spannung am mittleren Abgriff der Reihenschaltung der beiden Widerstände 26, 27 wird dem gemeinsamen Kollektor der Transistoren 22, 23 des ersten Stromspiegels 20 zugeführt. Der vom gemeinsamen Kollektor der Transistoren 22, 23 des ersten Stromspiegels 20 gebildete Knotenpunkt wird als Referenz K1 verwendet. Die Spannung am mittleren Abgriff der Reihenschaltung der beiden Widerstände 26, 27 wird weiter dem gemeinsamen Kollektor der Transistoren 24, 25 des zweiten Stromspiegels 21 zugeführt. An dem vom gemeinsamen Kollektor der Transistoren 24, 25 des zweiten Stromspiegels 21 gebildeten Knotenpunkt wird über einen Kondensator 28 sowie gegebenenfalls einen weiteren Spannungsteiler 29 das Nutzsignal K2 abgegriffen.

Der Widerstand 15 ist in der Art eines Stromshunts zwischen dem Emitter des einen Transistors 24 des zweiten Stromspiegels 21 und der Masse angeordnet. Ein nicht weiter gezeigter AD(Analog/Digital)-Wandler kann bei Bedarf mit dem Ausgang für das Nutzsignal K2 zur Auswertung des Nutzsignals K2, also für die Bestimmung der Größe des elektrischen Stroms, in Verbindung stehen. Schließlich kann gemäß Fig. 8a ein Komparator 17 mit dem Ausgang für das Referenzsignal K1 sowie mit dem Ausgang für das Nutzsignal K2 zur Auswertung des Differenzsignals zwischen dem Referenzsignal K1 und dem Nutzsignal K2, also für die Bestimmung der Größe des elektrischen Stroms, in Verbindung stehen. Wie bereits erwähnt, kann bei der Auswertung des Nutzsignals K2 und/oder des Referenzsignals K1 ein PWM(Puls-Weiten-Moduliertes)-Signal erzeugt werden, wobei das Tastverhältnis $\lambda$ des PWM-Signals zur Größe des elektrischen Stroms korrespondierend ist.

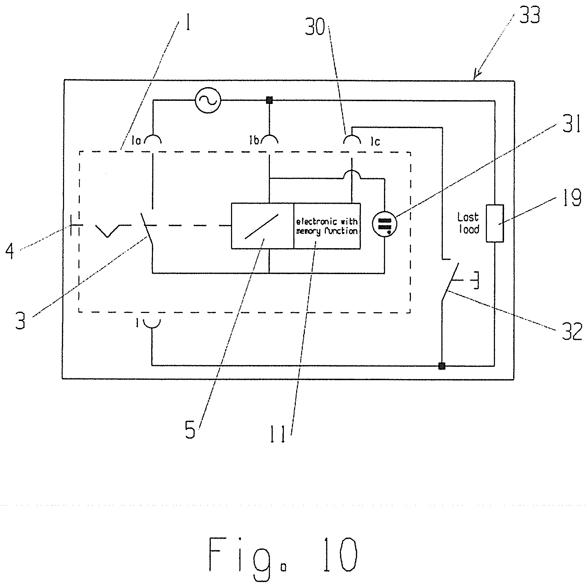

Wie bereits anhand von Fig. 2a ausgeführt, weist der Schalter 1 eine Elektronik 11 auf, die im Gehäuse 2 befindlich ist, und zwar auf einer im Gehäuse 2 befindlichen Leiterplatte 12 angeordnet ist. Am Schalter 1 ist ein in Fig. 10 gezeigter Eingang 30 zur Erfassung wenigstens eines Signals vorgesehen, wobei es sich bei dem Signal insbesondere um einen Messwert handelt. Der Eingang 30 kann als ein Anschluss 10 am Gehäuse 2 ausgestaltet sein. Das Signal wird dann über den Eingang 30 der Elektronik 11 zugeführt, die dann wiederum zur Auswertung des Signals dient. Bevorzugterweise handelt es sich bei der Elektronik 11 um einen Mikroprozessor beziehungsweise die Elektronik 11 umfasst in bevorzugter Weise einen Mikroprozessor. Nach Auswertung des Signals durch die Elektronik 11 wird eine zur Auswertung korrespondierende Aktion ausgelöst. Bei dieser Aktion handelt es sich beispielsweise um die Ansteuerung des Aktors 5 zum Schalten des Kontaktsystems 3 in die andere Schaltstellung und/oder um die Ansteuerung einer optischen Anzeige, die beispielsweise mittels einer in Fig. 10 dargestellten Beleuchtung 31 erfolgt. Bei dem Signal kann es sich um ein analoges und/oder ein digitales Signal handeln.

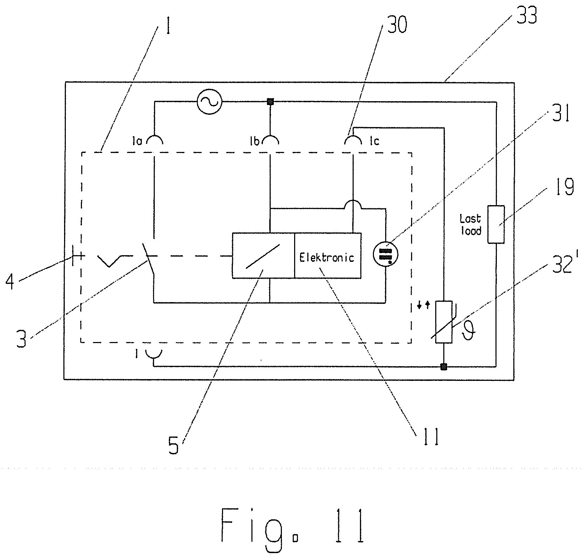

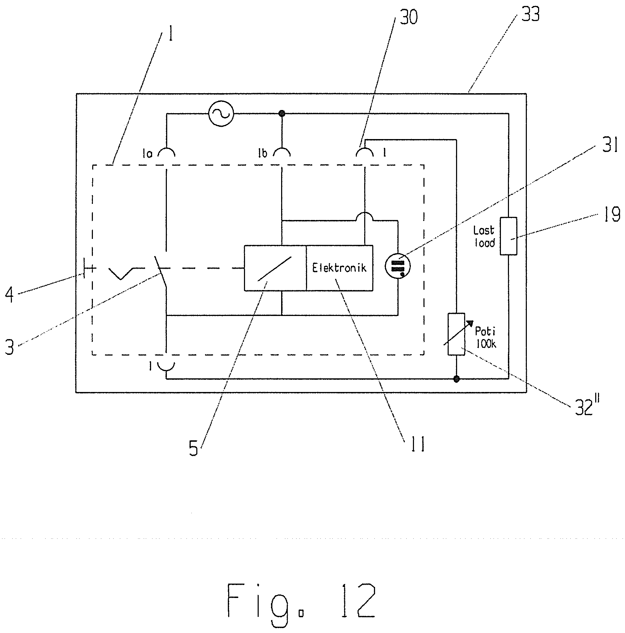

Bevorzugterweise handelt es sich bei dem Signal um ein externes Signal. Hierzu ist ein außerhalb des Gehäuses 2 befindlicher, externer Sensor 32 zur Erfassung und/oder Erzeugung des externen Signals vorgesehen. Als ein erstes Beispiel ist in Fig. 10, in der ein Blockschaltbild zur Integration einer benutzerspezifischen Programmierung des Schalters 1 durch den Anschluss eines externen Tasters an den Schalter 1 gezeigt ist, ein externes elektrisches Schaltelement als externer Sensor 32 zu sehen. Bei dem elektrischen Schaltelement 32 kann es sich beispielsweise um einen Tastschalter handeln, welcher wiederum zur benutzergesteuerten Programmierung der Elektronik 11 vorgesehen sein kann. Mit Hilfe des Schaltelements 32 kann so beispielsweise der weiter oben erwähnte Timer in der Elektronik 11 eingestellt werden. Ein zweites Beispiel in Fig. 11, in der ein Blockschaltbild für die Integration einer Temperaturmessung in den Schalter 1 zu sehen ist, zeigt als Sensor 32' einen Temperaturfühler. Der Temperaturfühler 32' dient zur Erfassung der Temperatur, die dann der Elektronik 11 zur weiteren Auswertung übermittelt wird. Ein drittes Beispiel in Fig. 12, in der ein Blockschaltbild für die Integration einer Widerstandsmessung in den Schalter 1 zu sehen ist, zeigt als Sensor 32" ein Potentiometer. Das Potentiometer 32" dient zur Erfassung einer Widerstandsänderung, die dann der Elektronik 11 zur weiteren Auswertung übermittelt wird. Als weiteres Beispiel für einen Sensor 32, das jedoch nicht weiter gezeigt ist, kann schließlich noch ein Fotoelement zur Erfassung von Licht genannt werden.

Desweiteren kann es sich bei dem Signal auch um ein internes Signal handeln. So kann das Signal den Stromverbrauch und/oder den Stromverlauf entsprechend den Betriebszuständen eines elektrischen Gerätes 33 und/oder die Einschaltzyklen eines elektrischen Gerätes 33, in dem der Schalter 1 verwendet ist, repräsentieren. Die Elektronik 11 kann dieses Signal dann im Hinblick auf die Betriebsdauer des Gerätes 33, die Belastung des Gerätes 33, auf eine erforderliche Wartung des Gerätes 33 o. dgl. auswerten.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann ein derartiger elektrischer Schalter 1 nicht nur für Kaffeemaschinen sondern auch in sonstigen Elektrogeräten, bei denen ein automatisches Um- und/oder Ausschalten ermöglicht sein soll, sowie bei sonstigen Hausgeräten, Gartengeräten, Elektrowerkzeugen o. dgl. Verwendung finden.

Bezugszeichen-Liste:

| | |
|---|---|
| 1: | (elektrischer) Schalter |
| 2: | Gehäuse |
| 3: | Kontaktsystem |
| 4: | Betätigungsorgan |
| 5: | Aktor |
| 6: | Spule |
| 7: | Anker |
| 8: | Stößel |
| 9: | Ansatz (am Betätigungsorgan) |
| 10: | (elektrischer) Anschluss |
| 11: | Elektronik |
| 12: | Leiterplatte |
| 13: | Programmierlasche |
| 15: | Widerstand / Shunt |
| 16: | Verstärker |
| 17: | Komparator |
| 18: | Ausgang (von Komparator) |
| 19: | Last |
| 20,21: | Stromspiegel |
| 22,23,24,25: | Transistoren (von Stromspiegel) |
| 26,27: | Widerstand |
| 28: | Kondensator |
| 29: | Spannungsteiler |
| 30: | Eingang (am Schalter) |
| 31: | Beleuchtung (am Schalter) |
| 32: | (externer) Sensor / (externes) Schaltelement |
| 32': | (externer) Sensor / Temperaturfühler |
| 32": | (externer) Sensor / Potentiometer |
| 33: | (elektrisches) Gerät |
| $K_1$: | Referenz |
| $K_2$: | Verstärker Stromsignal |
| A: | Ausgang |

**Patentansprüche**

1. Elektrischer Schalter für ein elektrisches Gerät (33) mit einem Kontaktsystem (3) sowie mit einem beweglichen Betätigungsorgan (4) zum Umschalten des Kontaktsystems (3) zwischen zwei Schaltstellungen, wobei es sich bei den Schaltstellungen um eine Einschalt- sowie eine Ausschalt-Stellung handelt, und mit einem ansteuerbaren Aktor (5), bei dessen Ansteuerung das Kontaktsystem (3) in die andere Schaltstellung geschaltet wird, insbesondere von der Einschalt- in die Ausschalt-Stellung des Kontaktsystems (3) geschaltet wird, wobei ein Mittel zur Messung des durch den Schalter (1) fließenden elektrischen Stroms vorgesehen ist, und wobei das Mittel zur Strommessung einen Widerstand (15) sowie gegebenenfalls einen Komparator (17) umfasst, **dadurch gekennzeichnet, dass** das Mittel zur Strommessung einen Verstärker (16) umfasst, und dass der Verstärker (16) aus zwei komplementär aufgebauten Stromspiegeln (20, 21) besteht.

2. Elektrischer Schalter nach Anspruch 1, **dadurch gekennzeichnet, dass** der Stromspiegel (20, 21) jeweils zwei Transistoren (22, 23, 24, 25) umfasst, und dass vorzugsweise eine Reihenschaltung aus zwei Widerständen (26, 27) zum Einprägen des Stroms in die Basen der Transistoren (22, 23, 24, 25) der beiden Stromspiegel (20, 21) vorgesehen ist.

3. Elektrischer Schalter nach Anspruch 1 oder 2, **dadurch gekennzeichnet, dass** die Spannung am mittleren Abgriff der Reihenschaltung der beiden Widerstände (26, 27) dem gemeinsamen Kollektor der Transistoren (22, 23) des ersten Stromspiegels (20) zugeführt wird, und dass vorzugsweise der vom gemeinsamen Kollektor der Transistoren (22, 23) des ersten Stromspiegels (20) gebildete Knotenpunkt als Referenz (K1) verwendet wird.

4. Elektrischer Schalter nach Anspruch 1, 2 oder 3, **dadurch gekennzeichnet, dass** die Spannung am mittleren Abgriff der Reihenschaltung der beiden Widerstände (26, 27) dem gemeinsamen Kollektor der Transistoren (24, 25) des zweiten Stromspiegels (21) zugeführt wird, und dass vorzugsweise an dem vom gemeinsamen Kollektor der Transistoren (24, 25) des zweiten Stromspiegels (21) gebildeten Knotenpunkt über einen Kondensator (28) sowie gegebenenfalls einen weiteren Spannungsteiler (29) das Nutzsignal (K2) abgegriffen wird.

5. Elektrischer Schalter nach einem der Ansprüche 1 bis 4, **dadurch gekennzeichnet, dass** der Widerstand (15) in der Art eines Stromshunts zwischen dem Emitter des einen Transistors (24) des zweiten Stromspiegels (21) und der Masse angeordnet ist, und dass vorzugsweise der Widerstand (15) als eine mäanderförmige Bahn an einem elektrischen Anschluss (10) des Schalters (1) ausgestaltet ist.

6. Elektrischer Schalter nach einem der Ansprüche 1 bis 5, **dadurch gekennzeichnet, dass** ein AD(Analog/Digital)-Wandler mit dem Ausgang für das Nutzsignal (K2) zur Auswertung des Nutzsignals (K2), insbesondere für die Bestimmung der Größe des elektrischen Stroms, in Verbindung steht.

7. Elektrischer Schalter nach einem der Ansprüche 1 bis 6, **dadurch gekennzeichnet, dass** der Komparator (17) mit dem Ausgang für das Referenzsignal (K1) sowie mit dem Ausgang für das Nutzsignal (K2) zur Auswertung des Differenzsignals zwischen dem Referenzsignal (K1) und dem Nutzsignal (K2), insbesondere für die Bestimmung der Größe des elektrischen Stroms, in Verbindung steht.

8. Elektrischer Schalter nach einem der Ansprüche 1 bis 7, **dadurch gekennzeichnet, dass** die Auswertung des Nutzsignals (K2) und/oder des Referenzsignals (K1) ein PWM(Puls-Weiten-Moduliertes)-Signal erzeugt, wobei insbesondere das Tastverhältnis des PWM-Signals zur Größe des elektrischen Stroms korrespondierend ist.

9. Elektrischer Schalter nach einem der Ansprüche 1 bis 8, **dadurch gekennzeichnet, dass** der ansteuerbare Aktor (5) mit dem Betätigungsorgan (4) in Wirkverbindung steht, derart dass das Betätigungsorgan (4) in wenigstens einer der beiden Schaltstellungen bei Ansteuerung des Aktors (5) vom Aktor (5) zum Schalten des Kontaktsystems (3) in die andere Schaltstellung bewegt wird.

10. Elektrischer Schalter nach einem der Ansprüche 1 bis 9, **dadurch gekennzeichnet, dass** es sich bei dem Aktor (5) um einen eine Spule (6) sowie einen Anker (7) aufweisenden Elektromagneten handelt, und dass vorzugsweise die Wirkverbindung zwischen dem Aktor (5) und dem Betätigungsorgan (4) mittels des Ankers (7) bewirkt wird, insbesondere indem der Anker (7) mittels eines Stößels (8) auf das Betätigungsorgan (4), bevorzugterweise auf einen Ansatz (9) am Betätigungsorgan (4), einwirkt.

11. Elektrischer Schalter nach einem der Ansprüche 1 bis 10, **dadurch gekennzeichnet, dass** es sich bei dem Schalter (1) um einen Wippschalter handelt.

**Claims**

1. Electrical switch for an electrical device (33) comprising a contact system (3) and a displaceable actuating member (4) for switching the contact system (3) between two switch positions, wherein the switch positions are a switch-on position and a switch-off position, and comprising an actuable actuator (5), in the case of whose actuation the contact system (3) is switched into another switch position, in particular from the switch-on into the switch-off position of the contact system (3), wherein a means is provided for measuring the electrical current flowing through the switch (1), and wherein the means for measuring current has a resistor (15) and optionally a comparator (17), is **characterised in that** the means for measuring current comprises an amplifier (16), and the amplifier (16) consists of two current mirrors (20, 21) built in a complementary manner.

2. Electrical switch according to claim 1, **characterised in that** the current mirror (20, 21) has two transistors (22, 23, 24, 25) and that preferably a series connection of two resistors (26, 27) is provided for applying the current into the bases of the transistors (22, 23, 24, 25) of the two current mirrors (20, 21).

3. Electrical switch according to claim 1 or 2, **characterised in that** the voltage on the middle tap of the series connection of the two resistors (26, 27) is fed to the common collector of transistors (22, 23) of the first current mirror (20) and that preferably the node point formed by the common collector of transistors (22, 23) of the first current mirror (20) is used as a reference (K1).

4. Electrical switch according to claim 1, 2 or 3, **characterised in that** the voltage on the middle tap of the series connection of the two resistors (26, 27) is fed to the common collector of the transistors (24, 25) of the second current mirror (21), and that preferably at the node point formed by the common collector of transistors (24, 25) of the second current mirror (21) the useful signal (K2) is tapped via a capacitor (28) and optionally a further voltage divider (29).

5. Electrical switch according to one of claims 1 to 4, **characterised in that** the resistor (15) is arranged in the manner of a current shunt between the emitter of the one transistor (24) of the second current mirror (21) and of the mass, and that preferably the resistor (15) is designed as a meandering path on an electrical connection (10) of the switch (1).

6. Electrical switch according to one of claims 1 to 5, **characterised in that** an AD (analogue/digital) converter is connected to the output for the useful signal (K2) for evaluating the useful signal (K2), in particular for determining the magnitude of electrical current.

7. Electrical switch according to one of claims 1 to 6, **characterised in that** the comparator (17) is connected to the output for the reference signal (K1) and to the output for the useful signal (K2) for evaluating the differential signal between the reference signal (K1) and the useful signal (K2), in particular for determining the magnitude of electrical current.

8. Electrical switch according to one of claims 1 to 7, **characterised in that** the evaluation of the useful signal (K2) and/or of the reference signal (K1) generates a PWM (pulse-width modulated) signal, wherein in particular the duty cycle of the PWM signal corresponds to the magnitude of the electrical current.

9. Electrical switch according to one of claims 1 to 8, **characterised in that** the actuable actuator (5) is operatively connected to the actuating member (4) such that the actuating member (4) is moved in at least one of the two switch positions by the actuator (5) for switching the contact system (3) when the actuator (5) is actuated.

10. Electrical switch according to one of claims 1 to 9, **characterised in that** the actuator (5) is an electromagnet comprising a coil (6) and an armature (7), and that preferably the operative connection between the actuator (5) and the actuating member (4) is effected by means of the armature (7), in particular **in that** the armature (7) acts by means of a tappet (8) on the actuating member (4), preferably on a projection (9) on the actuating member (4).

11. Electrical switch according to one of claims 1 to 10, **characterised in that** the switch (1) is a rocker switch.

**Revendications**

1. Interrupteur électrique pour un appareil électrique (33), comportant un système de contact (3), ainsi qu'un organe de manoeuvre mobile (4) pour commuter le système de contact (3) entre deux positions de commutation, dans lequel, pour ce qui concerne les positions de commutation, il s'agit d'une position de fermeture ainsi que d'une position d'ouverture, et un actionneur (5) pouvant être commandé, lors de la commande duquel le système de contact (3) est commuté dans l'autre position de commutation, en particulier est commuté de la position de fermeture à la position d'ouverture du système de contact (3), un moyen étant prévu pour la mesure du courant électrique s'écoulant à travers l'interrupteur (1), et le moyen de mesure du courant comprenant une résistance (15), ainsi qu'éventuellement un comparateur (17), **caractérisé en ce que** le moyen pour la mesure du courant comprend un amplificateur (16), et que l'amplificateur (16) est constitué de deux miroirs de courant (20,21) ayant des structures complémentaires.

2. Interrupteur électrique selon la revendication 1, **caractérisé en ce que** chaque miroir de courant (20, 21) comprend deux transistors (22, 23, 24, 25), et que de préférence un montage en série est prévu, constitué de deux résistances (26, 27), pour injecter le courant dans la base des transistors (22, 23, 24, 25) des deux miroirs de courant (20, 21).

3. Interrupteur électrique selon la revendication 1 ou 2, **caractérisé en ce que** la tension au niveau de la prise centrale du montage en série des deux résistances (26, 27) est amenée au collecteur commun des transistors (22, 23) du premier miroir de courant (20), et que de préférence le noeud formé par le collecteur commun des transistors (22, 23) du premier miroir de courant (20) est utilisé comme référence (K1).

4. Interrupteur électrique selon la revendication 1, 2 ou 3, **caractérisé en ce que** la tension au niveau de la prise centrale du montage en série des deux résistances (26, 27) est amenée au collecteur commun des transistors (24, 25) du deuxième miroir de courant (21), et que de préférence le signal utile (K2) est dérivé au niveau du noeud formé par le collecteur commun des transistors (24, 25) du deuxième miroir de courant (21), par l'intermédiaire d'un condensateur (28), ainsi qu'éventuellement d'un diviseur de tension (29) supplémentaire.

5. Interrupteur électrique selon l'une des revendications 1 à 4, **caractérisé en ce que** la résistance (15) est disposée à la manière d'un shunt de courant entre l'émetteur de l'un des transistors (24) du deuxième miroir de courant (21) et la terre, et que de préférence la résistance (15) est configurée comme une bande en forme de méandre contre un raccordement électrique (10) de l'interrupteur (1).

6. Interrupteur électrique selon l'une des revendications 1 à 5, **caractérisé en ce qu'**un convertisseur AN (analogique/numérique) est relié à la sortie servant au signal utile (K2), pour l'évaluation du signal utile (K2), en particulier pour l'évaluation de l'intensité du courant électrique.

7. Interrupteur électrique selon l'une des revendications 1 à 6, **caractérisé en ce que** le comparateur (17) est relié à la sortie servant au signal de référence (K1), ainsi qu'à la sortie servant au signal utile (K2), pour l'évaluation du signal différentiel entre le signal de référence (K1) et le signal utile (K2), ainsi que pour la détermination de l'intensité du courant électrique.

8. Interrupteur électrique selon l'une des revendications 1 à 7, **caractérisé en ce que** l'évaluation du signal utile (K2) et/ou du signal de référence (K1) produit un signal PWM (de modulation d'impulsion en durée), en particulier le taux d'impulsion du signal PWM étant en correspondance avec l'intensité du courant électrique.

9. Interrupteur électrique selon l'une des revendications 1 à 8, **caractérisé en ce que** l'actionneur (5) pouvant être commandé est en liaison opérationnelle avec l'organe de manoeuvre (4), de telle sorte que l'organe de manoeuvre (4) soit déplacé dans au moins l'une des deux positions de commutation lors de la commande de l'actionneur (5), sous l'effet de l'actionneur (5), pour commuter le système de contact (3) dans l'autre position de commutation.

10. Interrupteur électrique selon l'une des revendications 1 à 9, **caractérisé en ce que**, pour ce qui concerne l'actionneur (5), il s'agit d'un électro-aimant présentant une bobine (6), ainsi qu'un induit (7), et que de préférence la liaison opérationnelle entre l'actionneur (5) et l'organe de manoeuvre (4) est effectuée à l'aide d'un induit (7), en particulier par le fait que l'induit (7) agit par l'intermédiaire d'un coulisseau (8) sur l'organe de manoeuvre (4), de préférence sur un épaulement (9) de l'organe de manoeuvre (4).

11. Interrupteur électrique selon l'une des revendications 1 à 10, **caractérisé en ce que**, pour ce qui concerne l'interrupteur (1), il s'agit d'un interrupteur à bascule.

4

1

10      10      10

## Fig. 1a

4

2

10

## Fig. 1b

10   10   2

10

## Fig. 1c

**Fig. 2a**

**Fig. 2b**

**Fig. 2c**

Fig. 3

# Fig. 4

Fig. 5

Fig. 6a

Fig. 6b

Fig. 7a

Fig. 7b

Fig. 7c

Fig. 7d

Fig. 7e

Fig. 8a

Fig. 8b

**Fig. 9**

20
23
27
26
22

25
21
28
29
15
16

erster Stromspiegel

zweiter Stromspiegel

K1 Referenz

A+/REFERENZ

A+/INPHASE

K2 Nutzsignal

Stromshunt

24

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013008128 A1

- EP 2405539 A2